(19) Europäisches Patentamt / European Patent Office / Office européen des brevets

(11) **EP 3 312 600 B1**

(12) **EUROPÄISCHE PATENTSCHRIFT**

(45) Veröffentlichungstag und Bekanntmachung des Hinweises auf die Patenterteilung:
**07.08.2024** **Patentblatt 2024/32**

(51) Internationale Patentklassifikation (IPC):
**G01N 27/02** *(2006.01)* **G01N 27/08** *(2006.01)*
**G01R 27/22** *(2006.01)*

(21) Anmeldenummer: **17194967.0**

(22) Anmeldetag: **05.10.2017**

(52) Gemeinsame Patentklassifikation (CPC):
**G01N 27/023; G01N 27/025; G01N 27/08; G01R 27/22**

(54) **LEITFÄHIGKEITSSENSOR UND VERFAHREN ZUR BESTIMMUNG DER ELEKTRISCHEN LEITFÄHIGKEIT EINES FLÜSSIGEN MEDIUMS**

CONDUCTIVITY SENSOR AND METHOD FOR DETERMINING THE ELECTRICAL CONDUCTIVITY OF A LIQUID

CAPTEUR DE CONDUCTIVITÉ ET PROCÉDÉ DE DÉTERMINATION DE LA CONDUCTIVITÉ ÉLECTRIQUE D'UN MILIEU LIQUIDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.10.2016 DE 102016119508**

(43) Veröffentlichungstag der Anmeldung:
**25.04.2018 Patentblatt 2018/17**

(73) Patentinhaber: **KROHNE Messtechnik GmbH 47058 Duisburg (DE)**

(72) Erfinder: **VOGT, Michael 44797 Bochum (DE)**

(74) Vertreter: **Gesthuysen Patentanwälte Partnerschaftsgesellschaft mbB Huyssenallee 68 45128 Essen (DE)**

(56) Entgegenhaltungen:
**DE-A1- 102006 033 265    DE-A1- 19 537 059
JP-A- H09 329 633    JP-A- S62 157 559
US-A- 3 806 798    US-A- 4 810 963
US-A1- 2002 142 935    US-A1- 2004 012 395
US-A1- 2011 079 521**

**Beschreibung**

Die Erfindung geht aus von einem Leitfähigkeitssensor zur Messung der elektrischen Leitfähigkeit eines flüssigen Mediums. Der Leitfähigkeitssensor ist in Anspruch 1 definiert.

Darüber hinaus geht die Erfindung aus von einem Verfahren zur Bestimmung der elektrischen Leitfähigkeit eines flüssigen Mediums. Das Verfahren ist in Anspruch 8 definiert.

Aus dem Stand der Technik sind Leitfähigkeitssensoren bekannt, die die elektrische Leitfähigkeit einer Flüssigkeit entweder induktiv oder konduktiv bestimmen. Dabei hängt die Art der Bestimmung der elektrischen Leitfähigkeit insbesondere von der Größe, also dem Wert der zu erwartenden Leitfähigkeit ab. Grundsätzlich eignen sich konduktive Leitfähigkeitssensoren für den Nachweis von kleinen Leitfähigkeiten, während induktive Leitfähigkeitssensoren vorzugsweise für die Bestimmung großer Leitfähigkeiten eingesetzt werden.

Die elektrische Leitfähigkeit eines Mediums ist der Kehrwert des spezifischen Widerstandes. Daher wird die elektrische Leitfähigkeit durch die Messung des Widerstandes des zu untersuchenden Mediums bestimmt.

Konduktive Leitfähigkeitssensoren messen die elektrische Leitfähigkeit durch die Erfassung des ohmschen Widerstandes der Flüssigkeit, aus Stromstärke, Spannungsabfall und Geometrie der Messanordnung. Dazu weisen konduktive Leitfähigkeitssensoren in der Regel wenigstens zwei Elektroden auf, die in dem zu vermessenden Medium angeordnet sind, wobei ein elektrischer Kontakt zwischen den Elektroden nur durch das zu vermessende Medium hergestellt wird. An diese Elektroden wird zur Vermeidung oder zur Minimierung von Polarisationseffekten eine Wechselspannung angelegt. Zur Bestimmung des Widerstandes wird der durch die Flüssigkeit fließende Strom und die über der Flüssigkeit abfallende Spannung bestimmt. Unter Berücksichtigung der Geometrie der Messanordnung lässt sich dann der spezifische Widerstand und daraus die elektrische Leitfähigkeit der Flüssigkeit bestimmen.

Ein konduktiver Leitfähigkeitssensor mit zwei Elektroden ist beispielsweise aus dem Stand der Technik der DE 102 12 494 A1, aus der Druckschrift DE 195 37 059 C2, aus dem Dokument US 2002/0142935 oder aus der DE 196 43 967 A1 bekannt.

Eine Messanordnung mit wenigstens vier Elektroden ist beispielsweise aus der Druckschrift DE 2501812 C2, aus der DE 43 07 379 C1 sowie aus der DE 10 2005 026 052 B3 bekannt.

Im Unterschied zu der zuvor beschriebenen Bestimmung der elektrischen Leitfähigkeit, bei der die Elektroden mit dem zu vermessenden Medium galvanisch gekoppelt sind, basiert ein induktiver Leitfähigkeitssensor auf der Induktion eines Wirbelstroms in dem Medium mittels einer ersten Toroidspule, wobei der induzierte Wirbelstrom seinerseits ein Magnetfeld erzeugt, das vorzugsweise in einer zweiten Toroidspule einen Strom induziert, der messtechnisch erfasst wird. Die Größe des im Medium induzierten Wirbelstroms hängt von der interessierenden elektrischen Leitfähigkeit des Mediums ab, so dass der in der zweiten Toroidspule induzierte Strom (bzw. die dort induzierte Spannung bei hochohmigem Abgriff) ein Maß für die Mediumleitfähigkeit darstellt. Die beiden Spulen bilden praktisch Primär- und Sekundärseite eines Transformators, die über das in dem Medium induzierte elektrische Wirbelfeld gekoppelt sind.

Induktive Leitfähigkeitssensoren sind beispielsweise aus der Druckschrift DE 198 51 146 B4, aus der DE 10 2006 025 194 A1, aus der Druckschrift US 3,806,798 sowie aus dem Dokument DE 10 2006 056 174 A1 bekannt.

Die Druckschrift US 7,078,909 B2 offenbart einen induktiven Leitfähigkeitssensor umfassend eine Sende- und eine Empfangsspule, wobei die Sendespule in dem zu vermessenden Fluid einen Strom induziert, wobei der induzierte Strom mittels Elektroden, die Kontakt mit dem Fluid aufweisen, in eine Leiterschleife geführt wird und wobei die Empfangsspule den von der Leiterschleife geführten Strom induktiv erfasst. Demnach ist die Empfangsspule nicht unmittelbar im Bereich der von dem Fluid durchströmten Rohrleitung angeordnet. Alternativ können auch sowohl die Sende- als auch die Empfangsspule induktiv mit der Leiterschleife verbunden sein, wodurch der in dem Fluid induzierte Strom weder durch die Sendespule unmittelbar eingebracht noch durch die Empfangsspule unmittelbar erfasst wird. Dies hat den Vorteil, dass die Größe der Empfangsspule und die Größe der Sendespule unabhängig ist bzw. sind von dem Durchmesser der Rohrleitung, durch die das Fluid fließt.

Die zuvor beschriebenen Leitfähigkeitssensoren weisen jedoch den Nachteil auf, dass sie - prinzipbedingt - entweder für den Nachweis von hohen oder niedrigen Leitfähigkeiten ausgestaltet sind.

Aus den Dokumenten US 2004/012395 A1, JP H09 329633 A, US 4 810 963 A und JP S62 157559 A ist jeweils eine Vorrichtung bekannt, die zur Bestimmung der Leitfähigkeit sowohl wenigstens eine Spule als auch Elektroden einsetzt.

Ausgehend von dem dargelegten Stand der Technik liegt der Erfindung die Aufgabe zugrunde, einen Leitfähigkeitssensor und ein Verfahren zur Bestimmung der elektrischen Leitfähigkeit eines flüssigen Mediums anzugeben, mit denen ein besonders großer Wertebereich der elektrischen Leitfähigkeit bestimmt werden kann.

Erfindungsgemäß wurde erkannt, dass eine Kombination der aus dem Stand der Technik bekannten Verfahren die Messung eines besonders großen Wertebereichs der elektrischen Leitfähigkeit ermöglicht, wobei insbesondere mittlere Wertebereiche besonders gut erfasst werden können. Dabei gibt es grundsätzlich zwei alternative Messprinzipien, die verwirklicht werden können:

Gemäß dem induktiv-konduktiven Messprinzip (Grundlage der vorliegenden Erfindung) wird ein Stromfluss in dem flüssigen Medium induziert und der Stromfluss wird mittels mit der Flüssigkeit galvanisch gekoppelten Elektroden erfasst; dazu kann beispielsweise die durch den Stromfluss bewirkte elektrische Potenzialdifferenz zwischen den Elektroden ausgewertet werden. Gemäß dem umgekehrten konduktiv-induktiven Verfahren (nicht Teil der vorliegenden Erfindung) wird mittels galvanisch gekoppelten Elektroden ein elektrischer Strom in das flüssige Medium eingebracht und der Strom wird dann induktiv erfasst.

Gemäß einer ersten Lehre der vorliegenden Erfindung (induktiv-konduktives Messprinzip) wird die oben dargelegte Aufgabe durch einen Leitfähigkeitssensor zur Messung der elektrischen Leitfähigkeit eines flüssigen Mediums umfassend wenigstens eine erste Spule, vorzugsweise eine Sendespule zur Erzeugung eines sich zeitlich ändernden Magnetfeldes, eine Stromquelle und eine Ansteuerungs- und Auswerteeinheit, wobei die Stromquelle mit der ersten Spule verbunden ist, dadurch gelöst, dass zusätzlich wenigstens eine erste Elektrode und eine zweite Elektrode und wenigstens eine Spannungsmesseinheit vorhanden sind, wobei die Spannungsmesseinheit mit der ersten Elektrode und der zweiten Elektrode verbunden ist, wobei die Ansteuerungs- und Auswerteeinheit mit der Stromquelle und mit der Spannungsmesseinheit verbunden ist und wobei die erste Elektrode und die zweite Elektrode derart angeordnet sind, dass die erste Elektrode und die zweite Elektrode keinen elektrischen Kontakt mit der ersten Spule aufweisen.

Zur Realisierung des oben beschriebenen induktiv-konduktiven Messprinzips weist der Leitfähigkeitssensor wenigstens eine erste Spule, vorzugsweise eine Sendespule, zur Erzeugung eines sich zeitlich ändernden Magnetfeldes auf, wobei durch die erste Spule im Betrieb ein elektrisches Wirbelfeld in dem flüssigen Medium induziert wird. Im Fall einer nicht verschwindenden elektrische Leitfähigkeit resultiert daraus ein Stromfluss mit einer Stromdichte $J_F$, was im Weiteren einen Spannungsabfall über dem Strompfad in der Flüssigkeit zur Folge hat. Zur Erfassung dieses Spannungsabfalls sind eine erste und eine zweite Elektrode im Einflussbereich der ersten Spule angeordnet, wobei eine vorzugsweise hochohmige Spannungsmesseinheit vorhanden ist, mit welcher der an den beiden Elektroden anfallende Spannungsabfall messbar ist. Zudem weist der erfindungsgemäße Leitfähigkeitssensor eine Ansteuer- und Auswerteeinheit auf, die derart ausgestaltet ist, dass sie aus den Werten des Stromes und der Spannung die elektrische Leitfähigkeit des flüssigen Mediums bestimmt. Zusätzlich berücksichtigt die Ansteuer- und Auswerteeinheit zur Bestimmung der elektrischen Leitfähigkeit die Geometrie der Messanordnung, wobei die Messanordnung die Anordnung bzw. Ausgestaltung der ersten Spule sowie der ersten und der zweiten Elektrode umfasst.

Eine hochohmige Spannungsmesseinheit weist den Vorteil auf, dass kein wesentlicher Strom durch die erste und die zweite Elektrode fließt und keine die Messung nachhaltig störenden Polarisationseffekte an den Elektroden auftreten.

Der erfindungsgemäße Leitfähigkeitssensor ist geeignet sowohl zur Messung der Leitfähigkeit von deionisiertem Wasser bis hin zur Messung der elektrischen Leitfähigkeit von Säuren oder Laugen.

Zur Eliminierung unerwünschter Einflüsse auf die Messung von z. B. parasitären Schaltungselementen wie der Eigeninduktivität der Spule, können gemäß einer vorteilhaften Ausgestaltung innerhalb der Ansteuerungs- und Auswerteeinheit geeignete Ansätze und Methoden implementiert sein. Insbesondere weist die Ansteuerungs- und Auswerteeinheit eine Hinterlegung von analytischen Schaltungsmodellen und eine komplexe Auswertung im Fall von zeitharmonischen Größen auf. Darüber hinaus kann die Ansteuer- und Auswerteeinheit Kalibrierdaten, z. B. für eine Korrektur systematischer Messfehler, aufweisen, wobei die Kalibrierdaten in der Auswertung berücksichtigt werden.

Eine nicht erfindungsgemäße Ausgestaltung (konduktiv-induktives Messprinzip) betrifft eine komplementäre Verwendung der Elemente eines Leitfähigkeitssensors. Die nicht erfindungsgemäße Ausgestaltung betrifft einen Leitfähigkeitssensor zur Messung der elektrischen Leitfähigkeit eines flüssigen Mediums, umfassend wenigstens eine erste Elektrode und eine zweite Elektrode, wenigstens eine Strom- oder Spannungsquelle und eine Ansteuerungs- und Auswerteeinheit, wobei die Strom- oder Spannungsquelle mit der ersten Elektrode und der zweiten Elektrode verbunden ist, wobei zusätzlich wenigstens eine erste Spule, vorzugsweise eine Empfangsspule, und eine Strommesseinheit vorhanden sind, wobei die Strommesseinheit mit der ersten Spule verbunden ist, wobei die Ansteuerungs- und Auswerteeinheit mit der Strom- oder Spannungsquelle und mit der Strommesseinheit verbunden ist und wobei die erste Elektrode und die zweite Elektrode derart angeordnet sind, dass die erste Elektrode und die zweite Elektrode keinen elektrischen Kontakt mit der ersten Spule aufweisen.

Zur Realisierung des konduktiv-induktiven Messprinzips wird im Betrieb des Leitfähigkeitssensors über die Strom- oder Spannungsquelle und über die erste und die zweite Elektrode ein Strom oder eine Spannung, insbesondere ein Wechselstrom bzw. eine Wechselspannung, und insofern ein sich zeitlich änderndes elektrisches Feld in das flüssige Medium eingebracht. Die erste Spule ist derart angeordnet, dass durch das sich zeitlich ändernde elektrische Feld eine sich zeitlich ändernde magnetische Flussdichte in der ersten Spule induziert wird, wodurch im Ergebnis der Stromfluss durch die Spule gemessen werden kann. Da der Stromfluss von der elektrischen Leitfähigkeit des Mediums abhängt, kann so auf die elektrische Leitfähigkeit des Mediums geschlossen werden.

Gemäß einer ersten Ausgestaltung der Leitfähigkeitssensoren, also sowohl des Leitfähigkeitssensors gemäß dem induktiv-konduktiven Messprinzip wie auch des Leitfähigkeitssensors gemäß dem konduktiv-induktiven Messprinzip, ist die erste Spule eine Toroidspule, vorzugsweise mit einem ferromagnetischen Ringkern.

Gemäß einer weiteren vorteilhaften Ausgestaltung sind die erste und die zweite Elektrode als Ringelektroden ausgestaltet.

Darüber hinaus weisen die erste und die zweite Elektrode gemäß einer vorteilhaften Ausgestaltung eine elektrisch leitfähige, metallische Schicht auf, wobei im Betrieb über die metallische Schicht die über der zu vermessenden Flüssigkeit abfallende Spannung erfasst werden kann oder der Strom oder die Spannung in die Flüssigkeit eingebracht werden kann.

Erfindungsgemäß ist eine elektrisch isolierende Einheit in Form eines elektrisch isolierendes Rohrs vorhanden, wobei die elektrisch isolierende Einheit einen Innenraum und einen Außenraum aufweist, wobei der Innenraum offen ist, wobei die erste Spule die elektrisch isolierende Einheit umgibt und wobei die erste Spule und die erste und zweite Elektrode parallel zueinander entlang der elektrisch isolierenden Einheit angeordnet sind. Dabei ist die elektrisch isolierende Einheit derart ausgestaltet, dass im Betrieb des Leitfähigkeitssensors das zu vermessende Medium innerhalb der elektrisch isolierenden Einheit angeordnet ist, sodass ein elektrisches Feld in dem Medium aufgebaut werden kann.

Ein offener Innenraum ist erfindungsgemäß dadurch realisiert, dass die elektrisch isolierende Einheit rohrförmig, d. h. mit freiem Querschnitt ausgestaltet ist. Alternativ kann die elektrisch isolierende Einheit auch eine andere Form aufweisen, relevant ist lediglich, dass die elektrisch isolierende Einheit wenigstens eine Öffnung aufweist, durch die das Medium im Betrieb in die elektrisch isolierende Einheit eintreten und austreten kann.

Dabei ist es besonders vorteilhaft, wenn die erste und die zweite Elektrode im Innenraum und insbesondere an der Innenseite der elektrisch isolierenden Einheit angeordnet sind.

Gemäß einer weiteren vorteilhaften Ausgestaltung ist die erste Spule zwischen der ersten und der zweiten Elektrode angeordnet. Diese Ausgestaltung ist vorteilhaft, da im Betrieb des Sensors, das in dem flüssigen Medium durch Induktion oder durch Anlegen einer Potenzialdifferenz erzeugte elektrische Feld insbesondere im Bereich der ersten Spule, und sofern die erste Spule eine Toroidspule mit einem Ringkern ist, im Bereich des Ringkerns ausgebildet ist.

Besonders vorteilhaft ist es, wenn die erste Elektrode und die zweite Elektrode an den Enden der elektrisch isolierenden Einheit angeordnet sind. Dann weisen die erste und die zweite Elektrode einen maximalen Abstand zueinander auf. Ist die elektrisch isolierende Einheit als elektrisch isolierendes Rohr und sind die erste und die zweite Elektrode als Ringelektroden ausgestaltet, so weisen die erste und die zweite Elektrode vorzugsweise denselben Innen- und Außendurchmesser wie das elektrisch isolierende Rohr auf. Besonders bevorzugt sind die erste und die zweite Elektrode in das elektrisch isolierende Rohr integriert. Dies hat den Vorteil, dass die erste und die zweite Elektrode konstruktiv einfach zu realisieren sind und des Weiteren eine gute Abdichtung zwischen der ersten und der zweiten Elektrode und dem elektrisch isolierenden Rohr besonders einfach zu realisieren ist.

Alternativ können die erste Elektrode und die zweite Elektrode auf derselben Seite der ersten Spule angeordnet sein. Diese Anordnung ist vorteilhaft im Hinblick auf eine gute elektrische Entkopplung der ersten und der zweiten Elektrode von der ersten Spule. Diese Anordnung bewirkt insbesondere eine Unterdrückung unerwünschter Kopplungen über magnetische Streufelder der ersten Spule beispielsweise durch elektrische Felder zwischen den Windungen der ersten Spule.

Zur Vermeidung unerwünschter Verkopplungen zwischen der ersten Spule und der ersten und/oder der zweiten Elektrode ist es weiterhin vorteilhaft, wenn an wenigstens einer Seite der ersten Spule eine Abschirmung, insbesondere ein elektrisch leitfähiges und/oder ferromagnetisches Blech oder eine elektrisch leitfähige und/oder ferromagnetische Folie, angeordnet ist.

Gemäß einer besonders bevorzugten Ausgestaltung ist wenigstens eine zweite Spule vorhanden, wobei die zweite Spule mit der ersten Spule parallel oder in Serie geschaltet ist oder keine Verbindung mit der ersten Spule aufweist.

Dabei können die erste und die zweite Spule die gleiche Windungszahl aufweisen, alternativ kann die Windungszahl der zweiten Spule aber auch von der Windungszahl der ersten Spule abweichen.

Gemäß dieser Ausgestaltung kann in vorteilhafter Weise das Messkonzept der induktiv-konduktiven oder der konduktiv-induktiven Messung mit einer weiteren konduktiven und/oder induktiven Messung der elektrischen Leitfähigkeit kombiniert werden, um eine Selbstüberwachungsfunktion zu ermöglichen, welche insbesondere relevant ist im Rahmen der NAMUR-Empfehlung NE 107 "Selbstüberwachung und Diagnose von Feldgeräten". Darüber hinaus ermöglicht diese Ausgestaltung eine Variation der Geometrie der Messanordnung, welche bei der Bestimmung der Leitfähigkeit von der Ansteuer- und Auswerteeinheit ebenfalls berücksichtigt wird. Bezüglich einer genauen Ausgestaltung der Selbstüberwachungsfunktion sowie einer möglichen Variation der Geometrie der Messanordnung wird auf die entsprechende Beschreibung des erfindungsgemäßen Verfahrens verwiesen.

Es ist weiterhin vorteilhaft, wenn der Leitfähigkeitssensor gemäß einer nächsten Ausgestaltung ein Gehäuse aufweist, wobei zumindest die erste Spule und die erste und die zweite Elektrode innerhalb des Gehäuses angeordnet sind. Das Gehäuse schützt die in dem Gehäuse angeordneten Komponenten im Betrieb vor dem den Leitfähigkeitssensor umgebenden flüssigen Medium. Besonders vorteilhaft ist es, wenn das Gehäuse gleichzeitig wenigstens eine Abschirmung zur Vermeidung einer Kopplung zwischen der ersten Spule und der ersten und/oder der zweiten Elektrode aufweist. Dabei ist das Gehäuse mit der vorzugsweise vorhandenen Abschirmung derart ausgestaltet, dass ein die elektrisch isolierende Einheit umgebender magnetischer Fluss und ein freier Strompfad für die induzierten Wirbelströme erzeugt werden kann, wobei der Strompfad durch die mit dem flüssigen Medium gefüllte elektrisch isolierende Einheit und weiterhin durch den Außenbereich der elektrisch isolierenden Einheit führt.

Erfindungsgemäß ist der Leitfähigkeitssensor derart ausgestaltet, dass der Leitfähigkeitssensor im Betrieb eines der nachfolgend beschriebenen Verfahren durchführt.

Gemäß einer zweiten Lehre der vorliegenden Erfindung wird die eingangs genannte Aufgabe durch ein Verfahren zur Bestimmung der elektrischen Leitfähigkeit eines flüssigen Mediums mittels eines in dem flüssigen Medium angeordneten Leitfähigkeitssensors, wobei der Leitfähigkeitssensor wenigstens eine erste Spule, vorzugsweise eine Sendespule, eine Stromquelle und eine Ansteuerungs- und Auswerteeinheit aufweist, wobei die Stromquelle mit der ersten Spule verbunden ist, dadurch gelöst, dass zusätzlich wenigstens eine erste Elektrode und eine zweite Elektrode und eine Spannungsmesseinheit vorhanden sind, wobei die Spannungsmesseinheit mit der ersten Elektrode und der zweiten Elektrode verbunden ist und die Ansteuerungs- und Auswerteeinheit mit der Stromquelle und mit der Spannungsmesseinheit verbunden ist, wobei die erste Elektrode und die zweite Elektrode keinen elektrischen Kontakt mit der ersten Spule aufweisen und wobei die erste Elektrode und die zweite Elektrode über das flüssige Medium miteinander in Kontakt stehen, und dass das Verfahren die folgenden Schritte umfasst:

- Erzeugen eines Wechselstroms in der ersten Spule durch die Stromquelle, wodurch die erste Spule eine sich zeitlich ändernde magnetische Flussdichte erzeugt, die ein elektrisches Feld in dem flüssigen Medium induziert,

- Messen der Spannung zwischen der ersten Elektrode und der zweiten Elektrode durch die Spannungsmesseinheit,

- Übertragung der Werte der Spannung und des Stroms an die Ansteuer- und Auswerteeinheit,

- Bestimmen der elektrischen Leitfähigkeit aus den Werten der Spannung und des Stroms durch die Ansteuer- und Auswerteeinheit.

Zudem wird ein nicht erfindungsgemäßes Verfahren zur Bestimmung der elektrischen Leitfähigkeit eines flüssigen Mediums mittels eines in dem flüssigen Medium angeordneten Leitfähigkeitssensors beschrieben, wobei der Leitfähigkeitssensor wenigstens eine erste Elektrode und eine zweite Elektrode, wenigstens eine Strom- oder Spannungsquelle und eine Ansteuerungs- und Auswerteeinheit aufweist, wobei die Strom- oder Spannungsquelle mit der ersten Elektrode und der zweiten Elektrode verbunden ist, dadurch gelöst, dass zusätzlich wenigstens eine erste Spule und eine Strommesseinheit vorhanden sind, wobei die Strommesseinheit mit der ersten Spule verbunden ist, wobei die Ansteuerungs- und Auswerteeinheit mit der Strom- oder Spannungsquelle und mit der Strommesseinheit verbunden ist und wobei die erste Elektrode und die zweite Elektrode derart angeordnet sind, dass die erste Elektrode und die zweite Elektrode keinen elektrischen Kontakt mit der ersten Spule aufweisen und wobei die erste Elektrode und die zweite Elektrode über das flüssige Medium miteinander in Kontakt stehen, und dass das Verfahren die folgenden Schritte umfasst:

- Anlegen einer Wechselspannung oder eines Wechselstroms an die erste Elektrode und die zweite Elektrode durch die Strom- oder Spannungsquelle, wodurch ein sich zeitlich änderndes elektrisches Feld in das flüssige Medium eingebracht wird, wodurch eine sich zeitlich ändernde magnetische Flussdichte in die erste Spule induziert wird,

- Messen des Stromes, der durch die erste Spule fließt, durch die Strommesseinheit,

- Übertragen der Werte der Spannung und des gemessenen Stromes an die Ansteuer- und Auswerteeinheit,

- Bestimmen der elektrischen Leitfähigkeit aus den Werten der Spannung und des Stroms durch die Ansteuer- und Auswerteeinheit.

Ebenso wie die Leitfähigkeitssensoren weisen die Verfahren den Vorteil auf, dass durch die Kombination der induktiven bzw. konduktiven Einkopplung des sich zeitlich ändernden elektrischen Feldes in das flüssige Medium und die konduktive bzw. induktive Erfassung des elektrischen Feldes ein besonders großer Wertebereich der elektrischen Leitfähigkeit messbar ist, wobei die Verfahren insbesondere für den Nachweis von mittleren Werten der Leitfähigkeit geeignet sind.

Der an die erste Spule oder an die erste und die zweite Elektrode angelegte Wechselstrom oder die an die erste und die zweite Elektrode angelegte Wechselspannung weist vorzugsweise einen zeitharmonischen Verlauf auf, alternativ sind auch andere Verläufe über die Zeit denkbar.

Gemäß einer vorteilhaften Ausgestaltung weist der Leitfähigkeitssensor wenigstens eine zweite Spule auf, wobei die zweite Spule keine Verbindung mit der ersten Spule aufweist oder parallel oder in Serie zu der ersten Spule geschaltet ist und wobei die Bestimmung der elektrischen Leitfähigkeit sowohl mittels der ersten Spule als auch mittels der zweiten Spule, vorzugsweise über die Kombination der ersten Spule und der zweiten Spule erfolgt.

Dabei können die erste und die zweite Spule die gleiche Windungszahl aufweisen, alternativ kann die Windungszahl der zweiten Spule aber auch von der Windungszahl der ersten Spule abweichen.

Beispielsweise wird zunächst mittels der ersten Spule ein erstes elektrisches Feld in das Medium induziert und basierend auf dem ersten elektrischen Feld die elektrische Leitfähigkeit bestimmt und anschließend wird mittels der zweiten Spule ein zweites elektrisches Feld in das Medium induziert und basierend auf dem zweiten elektrischen Feld ebenfalls die Leitfähigkeit bestimmt. Dabei können die beiden Spulen von dem gleichen Wechselstrom durchflossen werden, alternativ kann der Wechselstrom, der durch die zweite Spule fließt, in seiner Amplitude und/oder seiner Phase und/oder seiner Frequenz von dem Wechselstrom der durch die erste Spule fließt abweichen.

Alternativ kann mittels der ersten und der zweiten Elektrode ein elektrisches Feld in die Flüssigkeit eingebracht werden, wobei zunächst über die erste Spule das elektrische Feld induktiv erfasst wird und anschließend über die zweite Spule.

Alternativ ist es denkbar, dass nach oder während der Bestimmung der elektrischen Leitfähigkeit mittels des induktiv-konduktiven Verfahrens oder nach der Bestimmung der elektrischen Leitfähigkeit mittels des konduktiv-induktiven Verfahrens die erste Spule ein elektrisches Feld in dem flüssigen Medium induziert, welches induktiv durch die zweite Spule erfasst wird.

Alternativ kann zu der induktiv-konduktiven bzw. der konduktiv-induktiven Bestimmung der elektrischen Leitfähigkeit, die Leitfähigkeit zusätzlich rein konduktiv mittels der ersten und der zweiten Elektrode bestimmt werden.

Ist die zweite Spule zu der ersten Spule parallel oder in Serie geschaltet, so erzeugen die Spulen gleichzeitig ein elektrisches Feld, welches sich vorzugsweise überlagert. Gemäß dieser Ausgestaltung kann der Messeffekt weiter verstärkt werden.

Insgesamt ist durch die redundante Bestimmung der elektrischen Leitfähigkeit zum einen die Möglichkeit gegeben, im Rahmen der Selbstüberwachung Fehlerquellen frühzeitig zu entdecken, und zum anderen die Möglichkeit, die Messanordnung zu variieren, wodurch die Genauigkeit und die Zuverlässigkeit der Bestimmung der Leitfähigkeit erhöht werden können. Insbesondere können je nach Art der Kombination der einzelnen Verfahren einzelne Komponenten des Leitfähigkeitssensors überprüft werden.

Besonders bevorzugt wird das Verfahren unter Einsatz eines der dargestellten Leitfähigkeitssensoren durchgeführt. Insbesondere sind alle beschriebenen Ausgestaltungen der Leitfähigkeitssensoren für die Kombination mit den Verfahren geeignet.

Im Einzelnen gibt es nun eine Vielzahl von Möglichkeiten, den erfindungsgemäßen Leitfähigkeitssensor und das erfindungsgemäße Verfahren auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung. In der Zeichnung zeigen

Fig. 1     einen ersten konduktiven Leitfähigkeitssensor aus dem Stand der Technik,
Fig. 2     einen zweiten konduktiven Leitfähigkeitssensor aus dem Stand der Technik,
Fig. 3     einen ersten induktiven Leitfähigkeitssensor aus dem Stand der Technik,
Fig. 4     einen zweiten induktiven Leitfähigkeitssensor aus dem Stand der Technik,
Fig. 5     ein erstes Ausführungsbeispiel eines erfindungsgemäßen Leitfähigkeitssensors,
Fig. 6     ein erstes elektrisches Ersatzschaltbild,
Fig. 7     ein zweites elektrisches Ersatzschaltbild,
Fig. 8     ein zweites Ausführungsbeispiel eines erfindungsgemäßen Leitfähigkeitssensors,
Fig. 9     ein drittes Ausführungsbeispiel eines erfindungsgemäßen Leitfähigkeitssensors,
Fig. 10    ein viertes Ausführungsbeispiel eines erfindungsgemäßen Leitfähigkeitssensors und
Fig. 11    ein weiteres Ausführungsbeispiel eines nicht erfindungsgemäßen Leitfähigkeitssensors
Fig. 12    ein erstes Ausführungsbeispiel eines erfindungsgemäßen Verfahrens,
Fig. 13    ein weiteres Ausführungsbeispiel eines nicht erfindungsgemäßen Verfahrens .

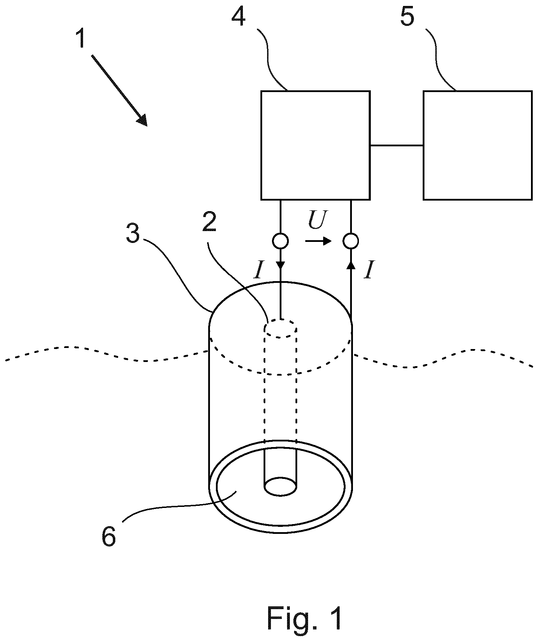

In Fig. 1 ist schematisch dargestellt ein konduktiver Leitfähigkeitssensor 1 aus dem Stand der Technik. Der Leitfähigkeitssensor 1 weist eine erste Elektrode 2 und eine zweite Elektrode 3 sowie eine Strom- oder Spannungsquelle mit einer Strom- und/oder Spannungsmesseinheit 4 auf. Zudem umfasst der Leitfähigkeitssensor 1 eine Ansteuer- und Auswerteeinheit 5, die mit der Strom- und Spannungsquelle mit einer Strom- und/oder Spannungsmesseinheit 4 verbunden ist. Im Betrieb ist der Leitfähigkeitssensor 1 zur Messung der elektrischen Leitfähigkeit $\kappa$ einer Flüssigkeit 6 in die Flüssigkeit 6 eingetaucht.

Zur Bestimmung der Leitfähigkeit $\kappa$ wird durch die Strom- oder Spannungsquelle 4 an die erste Elektrode 2 und an die zweite Elektrode 3 ein Wechselstrom $I$ oder eine Wechselspannung $U$ angelegt, und der durch die Flüssigkeit 6 fließende Strom $I$ und der über der Flüssigkeit 6 vorliegende Spannungsabfall $U$ werden von der Strom- und/oder Spannungsmesseinheit 4 erfasst. Aus den gemessen Werten des Stroms $I$ und der Spannung $U$ wird in der Ansteuer- und Auswerteeinheit 5 die Admittanz $Y_m = I/U$, also das Verhältnis des Wechselstroms zur an den Elektroden anliegenden Spannung bestimmt. Vernachlässigt man eventuell vorhandene Polarisationseffekte an den Elektroden, so lässt sich die Admittanz $Y_m$ in Real- und Imaginärteil folgendermaßen ausdrücken:

$$Y_{m,ideal} = \frac{I}{U} = G_m + jB_m \ \text{ mit } \ G_m = \text{Re}\{Y_m\} = \frac{\kappa}{k_{zell,kond}} \propto \frac{1}{R_F}$$

wobei $G_m$ der Wirkleitwert (Konduktanz), $B_m$ der Blindleitwert (Suszeptanz), $\kappa$ die elektrische Leitfähigkeit, $k_{Zell,kond}$ die Zellkonstante der Messanordnung und $R_F$ der ohmsche Widerstand des Strompfades ist. Die Zellkonstante $k_{zell,kond}$ ist abhängig von der Geometrie der Messanordnung, insbesondere der Fläche und des Abstandes der Elektroden. In der Anwendung eines solchen Leitfähigkeitssensors 1 sind die Polarisationseffekte an den Elektroden im Allgemeinen jedoch nicht zu vernachlässigen, was zusätzliche parasitäre Effekte zur Folge hat und die Hinzuziehung komplizierter Modelle für die Auswertung der Messungen erforderlich macht.

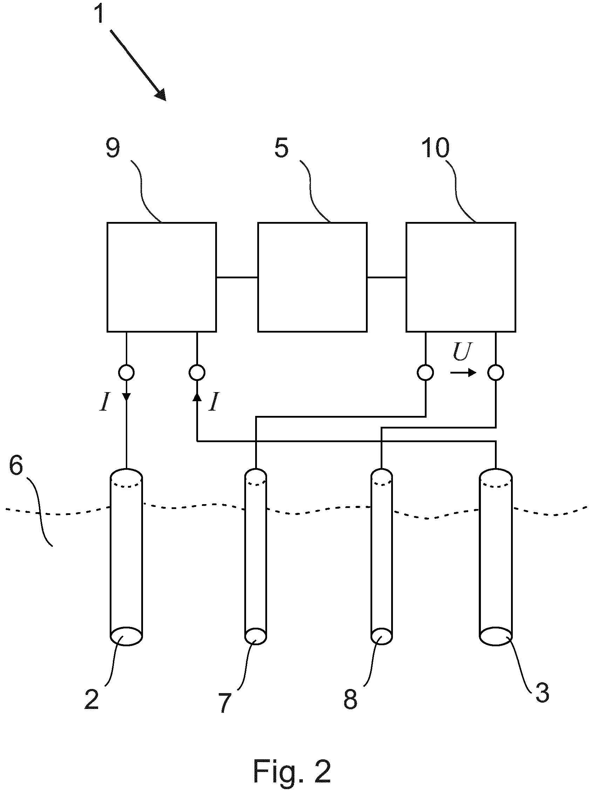

Fig. 2 zeigt ebenfalls einen konduktiven Leitfähigkeitssensor 1 aus dem Stand der Technik, wobei der Leitfähigkeitssensor 1 vier Elektroden 2, 3, 7, 8 aufweist, die im Betrieb in die zu vermessende Flüssigkeit 6 eingetaucht sind. Zudem weist der Leitfähigkeitssensor 1 eine Stromquelle 9, eine hochohmige Spannungsmesseinheit 10 und eine Ansteuer- und Auswerteeinheit 5 auf. Im Betrieb des dargestellten Leitfähigkeitssensors 1 wird über die äußeren Elektroden 2, 3 mit Hilfe der Stromquelle 9 ein Wechselstrom in die Flüssigkeit 6 eingebracht. Mit den beiden inneren Elektroden 7, 8 und mit Hilfe der hochohmigen Spannungsmesseinheit 10 wird ein Spannungsabfall über der Flüssigkeit 6 abgegriffen. Aufgrund des hochohmigen Abgriffs fließt kein wesentlicher Strom durch die beiden inneren Messelektroden 7, 8, womit keine die Messung störenden Polarisationseffekte an diesen beiden Elektroden auftreten. Wie oben bereits beschrieben bestimmt die Ansteuer- und Auswerteeinheit 5 aus der Admittanz $Y_m$ in Abhängigkeit von den Werten des Stromes und der Spannung die elektrische Leitfähigkeit $\kappa$.

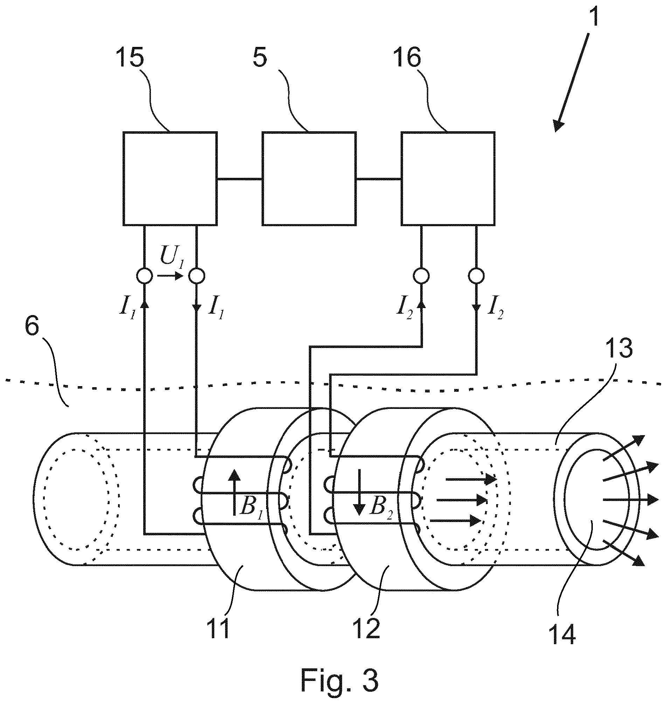

Fig. 3 zeigt einen induktiven Leitfähigkeitssensor 1 aus dem Stand der Technik, wobei der induktive Leitfähigkeitssensor 1 eine erste Spule 11, hier eine Sendespule in Form einer Toroidspule und eine zweite Spule 12 als Empfangsspule ebenfalls in Form einer Toroidspule aufweist. Zudem weist der Leitfähigkeitssensor 1 ein elektrisch isolierendes Rohr 13 mit einem freien Rohrquerschnitt 14 auf, wobei die erste Spule 11 und die zweite Spule 12 parallel zueinander um das elektrisch isolierende Rohr 13 angeordnet sind. Im Betrieb ist das elektrisch isolierende Rohr 13 mit der ersten Spule 11 und der zweiten Spule 12 derart in einer Flüssigkeit 6 angeordnet, dass sich die Flüssigkeit 6 innerhalb des elektrisch isolierenden Rohrs 13 befindet. Die erste Spule 11 ist weiterhin mit einer Spannungsquelle 15 verbunden und die zweite Spule 12 ist mit einer niederohmigen Strommesseinheit 16 verbunden. Darüber hinaus ist eine Ansteuer- und Auswerteeinheit 5 vorhanden, welche mit der Spannungsquelle 15 und der Strommesseinheit 16 verbunden ist. Im Betrieb wird durch das Anlegen einer Wechselspannung an die erste Spule 11 eine sich ändernde magnetische Flussdichte $B_1$ erzeugt, wodurch ein Wirbelstrom mit der Stromdichte $J_F$ in der Flüssigkeit 6 induziert wird. Dieser fließende Wirbelstrom wird induktiv von der zweiten Spule 12 erfasst. D. h der in der Flüssigkeit 6 fließende Wirbelstrom erzeugt eine sich ändernde magnetische Flussdichte $B_2$ in der zweiten Spule 12, sodass in der Folge ein durch die zweite Spule 16 fließender Strom durch die Strommesseinheit 16 gemessen werden kann. In der Ansteuer- und Auswerteeinheit 5 wird dann wie bereits dargelegt aus der gemessenen Admittanz $Y_m$ die elektrische Leitfähigkeit $\kappa$ bestimmt.

Die Admittanz $Y_m$ weist im dargestellten Beispiel folgende Beziehung auf:

$$Y_m = \frac{I_2}{U_1} = G_m + jB_m$$

wobei

$$G_m = \text{Re}\{Y_m\} = \frac{1}{N_1 \cdot N_2 \cdot R_F} = \frac{\kappa}{k_{zell,ind,2Spulen}} \ \text{ mit } R_F \propto \frac{1}{\kappa},$$

und wobei $k_{zell,ind,2Spulen}$ proportional zu $N_1 \cdot N_2$ und $N_1$ die Wicklungszahl der ersten Spule und $N_2$ die Wicklungszahl der zweiten Spule ist.

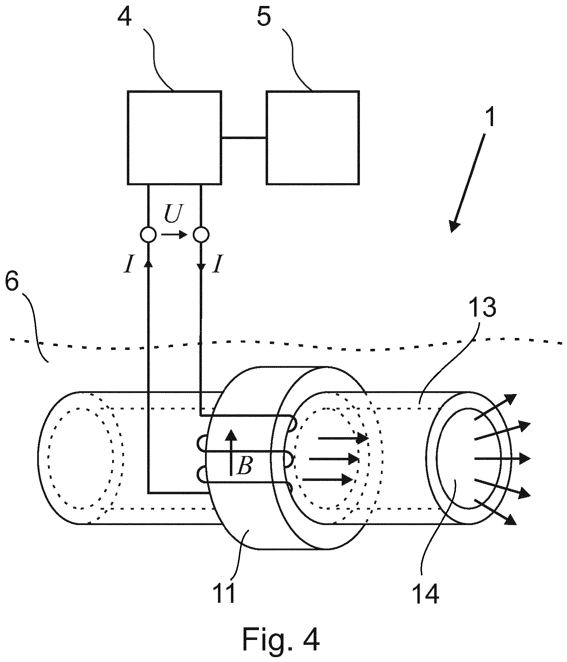

Fig. 4 zeigt ebenfalls einen induktiven Leitfähigkeitssensor 1 aus dem Stand der Technik, wobei der dargestellte Leitfähigkeitssensor 1 lediglich eine erste Spule 11 aufweist. Diese Spule 11 ist um ein elektrisch isolierendes Rohr 13 mit einem freien Rohrquerschnitt 14 angeordnet, welches im Betrieb in eine Flüssigkeit 6 eingetaucht ist. Zudem ist eine Strom- oder Spannungsquelle mit Strom- und/oder Spannungsmesseinheit 4 sowie eine Ansteuer- und Auswerteeinheit 5, die mit der Strom- oder Spannungsquelle mit Strom- und Spannungsmesseinheit 4 verbunden ist, dargestellt.

Da lediglich eine Spule 11 vorhanden ist, besteht das Messkonzept nun darin, die Eingangsimpedanz an den Anschlussklemmen der Spule 11 zu messen, wozu die Strom- oder Spannungsquelle mit Strom- und/oder Spannungsmesseinheit 4 eingesetzt wird.

Wie oben bereits dargelegt, bestimmt die Ansteuer- und Auswerteeinheit 5 die Admittanz $Y_m$, für die hier folgende Zusammenhänge gelten:

$$Y_m = \frac{I}{U} = \frac{1}{N^2} \cdot \left( \frac{1}{R_F} + \frac{N^2}{j\omega L} \right) = G_m + jB_m \ \ \text{mit} \ \ R_F \propto \frac{1}{\kappa},$$

wobei $N$ die Windungszahl der Spule 11 und $L$ die Eigeninduktivität der Spule 11 ist.

Daraus folgt, wie oben:

$$G_m = \text{Re}\{Y_m\} = \frac{1}{N^2 \cdot R_F} = \frac{\kappa}{k_{zell,ind,1Spule}},$$

wobei die Zellkonstante $k_{zell,ind,1Spule}$ proportional zu $N^2$ ist.

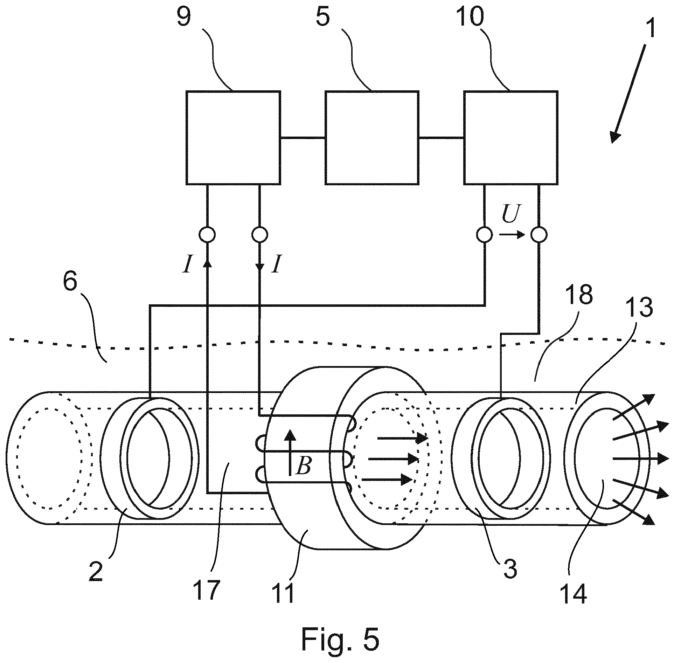

In Fig. 5 ist nun ein erstes Ausführungsbeispiel eines erfindungsgemäßen Leitfähigkeitssensors 1 dargestellt, wobei der Leitfähigkeitssensor 1 im Betrieb basierend auf einem induktiv-konduktiven Messprinzip die elektrische Leitfähigkeit $\kappa$ der Flüssigkeit 6 bestimmt. Der dargestellte Leitfähigkeitssensor 1 umfasst eine erste Spule 11 als Sendespule in Form einer Toroidspule, eine erste Elektrode 2 und eine zweite Elektrode 3 und ein elektrisch isolierendes Rohr 13 mit freiem Rohrquerschnitt 14, das im Betrieb mit der zu vermessenden Flüssigkeit 6 gefüllt ist und von der Flüssigkeit 6 umgeben ist. Zudem ist das elektrisch isolierende Rohr 13 von der ersten Spule 11 umgeben. Das elektrisch isolierende Rohr 13 weist weiterhin einen Innenraum 17 und einen Außenraum 18 auf. Im Innenraum 17 sind an der Innenseite des elektrisch isolierenden Rohrs 13 die erste Messelektrode 2 und die zweite Messelektrode 3 angebracht, wobei die erste Messelektrode 2 und die zweite Messelektrode 3 als metallische Ringelektroden ausgestaltet sind.

Zudem ist eine Stromquelle 9 vorhanden, wobei die Stromquelle 9 mit der ersten Spule 11 verbunden ist, wobei im Betrieb die ersten Spule 11 mit einem Wechselstrom beaufschlagt wird. Der durch die erste Spule 11 fließende Wechselstrom bewirkt eine sich zeitlich ändernde magnetische Flussdichte $B$ im Bereich der ersten Spule 11, wobei die sich zeitlich ändernde magnetische Flussdichte $B$ ein sich zeitlich änderndes elektrisches Feld $E_F$ innerhalb der Flüssigkeit 6 erzeugt. Daraus resultiert im Fall einer nicht verschwindenden elektrischen Leitfähigkeit $\kappa$ der Flüssigkeit 6 ein elektrischer Stromfluss in Form eines Wirbelstroms mit einer Stromdichte $J_F$ entlang eines geschlossenen Strompfades, der durch den freien Rohrquerschnitt 14 und durch den mit der Flüssigkeit 6 gefüllten Bereich des Außenraums 18 des elektrisch isolierenden Rohrs 13 gebildet wird. Verknüpft mit der Stromdichte $J_F$ ergibt sich ein elektrisches Feld $E_F$ innerhalb der Flüssigkeit 6, was zu einem sich zeitlich ändernden elektrischen Spannungsabfall $U$ zwischen der ersten Elektrode 2 und der zweiten Elektrode 3 führt. Die zwischen der ersten Elektrode 2 und der zweiten Elektrode 3 anliegende Spannung $U$ wird mit Hilfe einer hochohmigen Spannungsmesseinheit 10 abgegriffen und messtechnisch erfas st.

Mit der Stromquelle 9 und der Spannungsmesseinheit 10 ist eine Ansteuer- und Auswerteeinheit 5 verbunden. Die Ansteuer- und Auswerteeinheit 5 ist derart ausgestaltet, dass sie im Betrieb die elektrische Leitfähigkeit $\kappa$ aus den Größen Strom $I$ und Spannung $U$ bestimmt, wobei die zeitlichen Verläufe beider Größen, im Fall von zeitharmonischen Größen insbesondere deren Amplituden und Phasen, ausgewertet werden. Zu Eliminierung unerwünschter Einflüsse von z. B. parasitären Schaltungselementen, wie beispielsweise der Eigeninduktivität der Spule oder magnetischer Verluste im Ringkern, können innerhalb der Ansteuer- und Auswerteeinheit 5 geeignete Ansätze und Methoden implementiert sein. Zudem sind in der Ansteuer- und Auswerteeinheit 5 Kalibrierdaten hinterlegt, z. B. für eine Korrektur systematischer Messfehler, die in die Auswertung einbezogen werden.

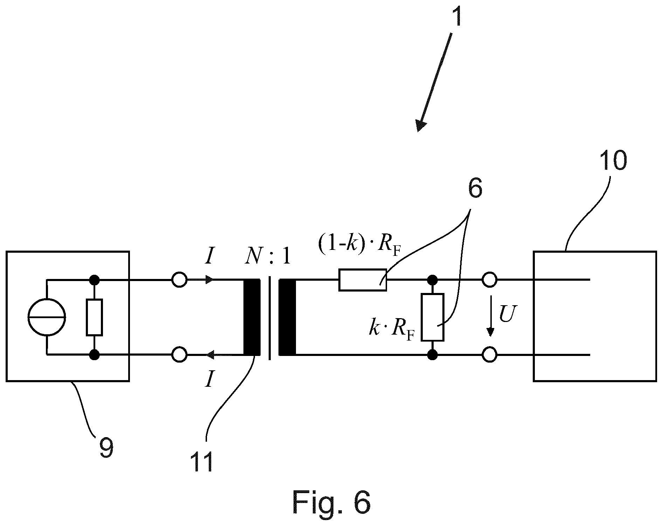

In Fig. 6 ist ein elektrisches Ersatzschaltbild des Funktionsprinzips eines induktiv-konduktiven Leitfähigkeitssensors 1, wie er beispielsweise in Fig. 5 dargestellt ist. Dargestellt ist ein Übertrager, wobei die Primärseite durch die erste Spule 11 mit der Windungszahl $N$ repräsentiert ist und die Sekundärseite mit der Windungszahl 1 durch den geschlossenen Strompfad durch die Flüssigkeit 6. Der ohmsche Widerstand $R_F$ des Strompfades teilt sich auf in einen ersten Teilwiderstand $k \cdot R_F$ mit $0 < k < 1$ entlang des Strompfades zwischen der ersten Elektrode 2 und der zweiten Elektrode 3 über den Außenraum 18 des elektrisch isolierenden Rohres 13 und in einen zweiten Teilwiderstand $(1-k) \cdot R_F$ zwischen der ersten Elektrode 2 und der zweiten Elektrode 3 entlang des Strompfades im Innenraum 17 des elektrisch isolierenden Rohres 13. In der Messanordnung gemäß Fig. 6 werden der Strom $I$ und die Spannung $U$ gemessen und in der Ansteuerungs- und Auswerteeinheit 5 wird aus der Admittanz $Y_m$ die elektrische Leitfähigkeit $\kappa$ bestimmt.

Bezüglich des folgenden Zusammenhangs zwischen der sekundärseitigen Spannung $U$ und dem primärseitigen Strom $I$ wird ebenfalls auf die Darstellung in Fig. 6 verwiesen.

$$Y_m = \frac{I}{U} = \frac{1}{k \cdot N} \cdot \left( \frac{1}{R_F} + \frac{N^2}{j\omega L} \right) = G_m + jB_m \ \ \text{mit} \ R_F \propto \frac{1}{\kappa} \ .$$

Damit die Messung der elektrischen Leitfähigkeit $\kappa$ der Flüssigkeit 6 unabhängig wird von der Eigeninduktivität $L$ der Spule 11, kann $Y_m$ vorteilhaft getrennt nach Real- und Imaginärteil erfasst und ausgewertet werden:

$$G_m = \text{Re}\{Y_m\} = \frac{1}{k \cdot N \cdot R_F} = \frac{\kappa}{k_{zell,indkond}} \ .$$

Dabei ist $k_{zell,indkond} \sim N$ die Zellkonstante des induktiv-konduktiven Leitfähigkeitssensors 1, wobei $k_{zell,indkond}$ abhängig ist von der Windungszahl $N$ der ersten Spule 11 und der Geometrie des Leitfähigkeitssensors 1.

Im Ergebnis wird damit induktiv ein Strom in Form eines Wirbelstroms in die Flüssigkeit 6 eingeprägt und der daraus resultierende Spannungsabfall zwischen der ersten Messelektrode 2 und der zweiten Messelektrode 3 wird galvanisch gekoppelt abgegriffen.

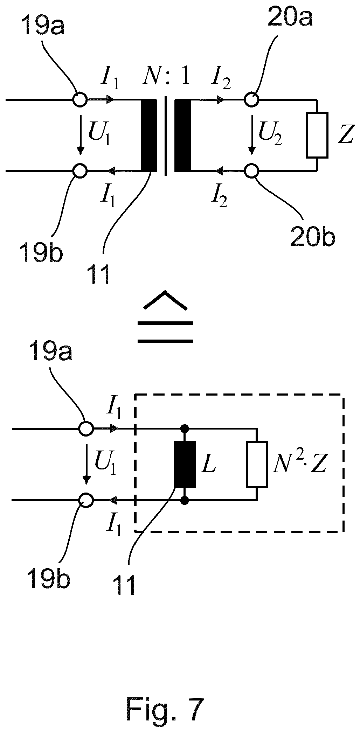

Fig. 7 zeigt ein elektrisches Ersatzschaltbild für den aus der ersten Spule 11 mit der Eigeninduktivität $L$ und der Windungszahl $N$ und aus dem geschlossenen Strompfad durch die Flüssigkeit 6 gebildeten Übertrager, wobei in der Darstellung eine ideale, verlustfreie Kopplung vorausgesetzt wird. $U_1$ bzw. $I_1$ bezeichnen die Spannung bzw. den Strom an der Primärseite und $U_2$ bzw. $I_2$ die Spannung bzw. den Strom an der Sekundärseite. Die Spannung $U_1$ an der Primärseite wird mit einem Klemmenpaar 19a, 19b abgegriffen und die Spannung $U_2$ an der Sekundärseite mit einem Klemmenpaar 20a, 20b. Die Darstellung zeigt den allgemeingültigen Fall, dass die Sekundärseite mit dem Klemmenpaar 20a und 20b mit einer Abschlussimpedanz $Z$ abgeschlossen ist.

Die Eingangsimpedanz $Z_{E1}$ in die Primärseite (Klemmenpaar 19a, 19b) ergibt sich dann wie in der unteren Teilabbildung dargestellt:

$$Z_{E1} = \frac{U_1}{I_1} = \frac{1}{\dfrac{1}{j\omega L} + \dfrac{1}{N^2 \cdot Z}} \ ,$$

wobei $\omega$ die Kreisfrequenz des angelegten Wechselstroms ist.

$$U_2 = \frac{U_1}{N} \ .$$

Ferner gilt allgemein für den Übertrager:

Werden die zuvor dargelegten Zusammenhänge bei der Bestimmung der Admittanz $Y_m$ der in Fig. 6 dargestellten Messanordnung berücksichtigt, ergeben sich die zu Fig. 6 dargelegten Zusammenhänge.

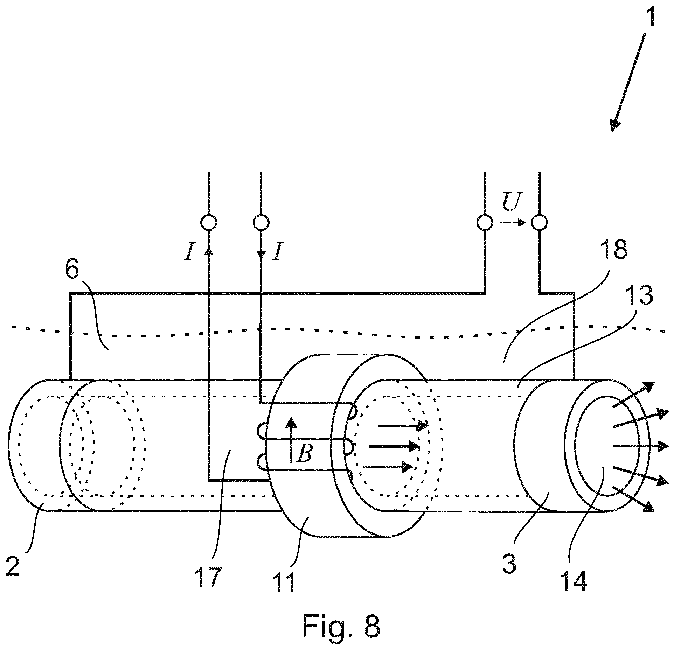

Fig. 8 zeigt ein zweites Ausführungsbeispiel eines erfindungsgemäßen Leitfähigkeitssensors 1, wobei im Unterschied zu dem in Fig. 5 dargestellten ersten Ausführungsbeispiel die erste Elektrode 2 und die zweite Elektrode 3 an den Enden des elektrisch isolierenden Rohres 13 angeordnet sind. Die metallischen Oberflächen der ersten Elektrode 2 und der zweiten Elektrode stehen sowohl im Innenbereich 17 des elektrisch isolierenden Rohrs 13 als auch im Außenbereich 18 des elektrisch isolierenden Rohrs in galvanischem Kontakt mit der Flüssigkeit 6.

Dabei weisen die erste Elektrode 2 und die zweite Elektrode 3 denselben Innen- und Außendurchmesser wie das elektrisch isolierende Rohr 13 auf.

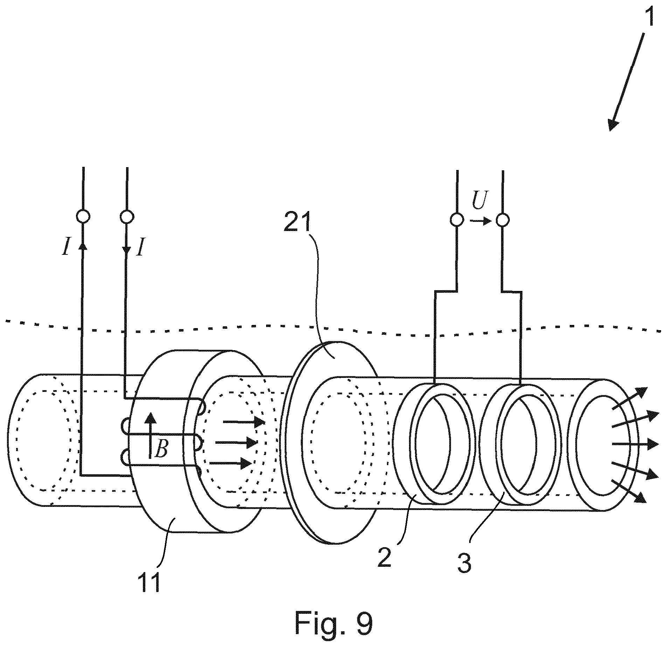

Fig. 9 zeigt ein drittes Ausführungsbeispiel eines erfindungsgemäßen Leitfähigkeitssensors 1, der ein induktiv-konduktives Messprinzip realisiert. Gemäß dem dargestellten Ausführungsbeispiel sind die erste Elektrode 2 und die zweite Elektrode 3 auf derselben Seite der ersten Spule 11 angeordnet. Dies ist vorteilhaft im Hinblick auf eine gute elektrische Entkopplung der ersten Elektrode 2 und der zweiten Elektrode 3 von der ersten Spule 11, insbesondere zur Unterdrückung unerwünschter Verkopplungen über magnetische Streufelder der ersten Spule 11 durch elektrische Felder zwischen den Windungen der ersten Spule 11.

Zur weiteren Vermeidung unerwünschter Kopplungen ist eine Abschirmung 21 in Form eines elektrisch leitfähigen Blechs zwischen der ersten Spule 11 und der ersten Elektrode 2 und der zweiten Elektrode 3 vorhanden.

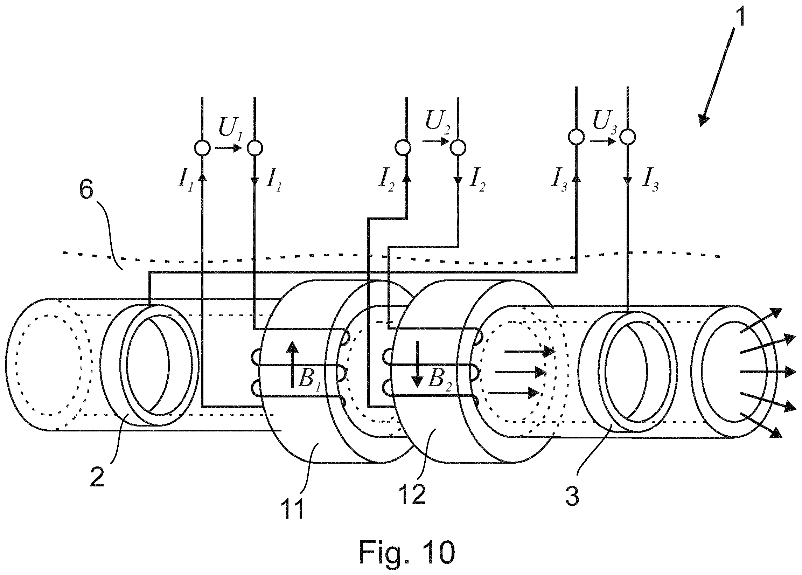

Fig. 10 zeigt ein viertes Ausführungsbeispiel eines erfindungsgemäßen Leitfähigkeitssensors 1, wobei neben der ersten Spule 11 eine zweite Spule 12 vorhanden ist, die sowohl als Sendespule als auch als Empfangsspule eingesetzt werden kann. Diese Ausgestaltung weist den Vorteil auf, dass das induktiv-konduktive Messverfahren gekoppelt werden kann, beispielsweise mit einer zusätzlichen induktiv-konduktiven Messung, wobei die zweite Spule 12 als Sendespule arbeitet oder mit einer zusätzlichen induktiven Messung, wobei die zweite Spule 12 induktiv den von der ersten Spule 11 in die Flüssigkeit 6 eingeprägten Strom erfasst. Eine mehrfache Erfassung der elektrischen Leitfähigkeit κ hat den Vorteil, dass der Leitfähigkeitssensor 1 eine integrierten Selbstüberwachungsfunktion aufweist.

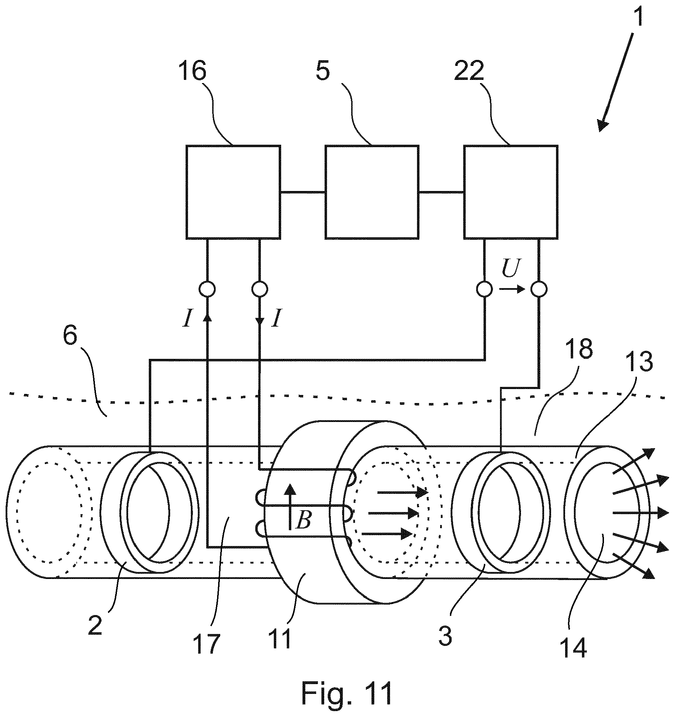

Fig. 11 zeigt ein fünftes nicht erfindungsgemäßes Beispiel eines Leitfähigkeitssensors 1, umfassend eine erste Spule 11, die hier als Empfangsspule eingesetzt wird, eine erste Elektrode 2 und eine zweite Elektrode 3, wobei die erste Spule 11 ein elektrisch isolierendes Rohr 13 umgibt, und wobei die erste Elektrode 2 und die zweite Elektrode 3 an der Innenseite des Rohrs angeordnet sind. Die erste Elektrode 2 und die zweite Elektrode 3 sind mit einer Spannungs- oder Stromquelle 22 verbunden. Die erste Spule 11 ist mit einer Strommesseinheit 16 verbunden. Sowohl die Spannungs- oder Stromquelle 22 als auch die Strommesseinheit 16 sind mit einer Ansteuer- und Auswerteeinheit 5 verbunden. In der Darstellung ist das elektrisch isolierende Rohr 13 in die zu vermessende Flüssigkeit 6 eingetaucht.

Im Betrieb wird an die erste Elektrode 2 und an die zweite Elektrode 3 eine Wechselspannung oder ein Wechselstrom angelegt, wodurch sich in der Flüssigkeit 6 ein sich änderndes elektrische Feld ausbildet. Dieses sich zeitlich ändernde elektrische Feld erzeugt eine magnetische Flussdichte B in der ersten Spule 11, wodurch ein Strom durch die erste Spule 11 messbar ist. Aus der Admittanz $Y_m$ bestimmt die Ansteuer- und Auswerteeinheit 5, wie oben dargelegt, die elektrische Leitfähigkeit κ. Im Unterschied zu den bisher beschriebenen Ausführungsbeispielen realisiert der in Fig. 11 dargestellte Leitfähigkeitssensor 1 ein konduktiv-induktives Messprinzip.

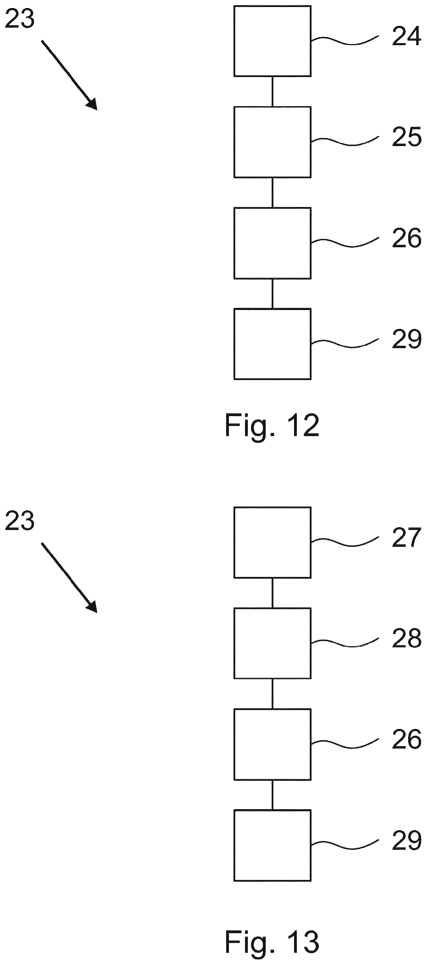

Fig. 12 zeigt ein erstes Ausführungsbeispiel eines erfindungsgemäßen Verfahrens 23 zur Bestimmung der elektrischen Leitfähigkeit κ eines flüssigen Mediums 6 mittels eines oben dargestellten Leitfähigkeitssensors 1, der ein induktiv-konduktives Verfahren realisiert. In einem ersten Schritt 24 wird die erste Spule 11 mit einem Wechselstrom beaufschlagt. Dieser erzeugt eine sich zeitlich ändernden magnetische Flussdichte $B$, wodurch ein elektrisches Wirbelfeld in der Flüssigkeit 6 induziert wird. In einem nächsten Schritt 25 wird über die erste Elektrode 2 und über die zweite Elektrode 3 der Spannungsabfall über der Flüssigkeit 6 bestimmt. Nach der Übergabe der gemessenen Werte an die Ansteuer- und Auswerteeinheit 5 bestimmt diese in einem weiteren Schritt 26 aus der Admittanz $Y_m$ die elektrische Leitfähigkeit κ der Flüssigkeit. In einem letzten Schritt 29 erfolgt eine zweite Messung der elektrischen Leitfähigkeit κ mittels eines konduktiven oder induktiven Verfahrens, wodurch die erste Messung überprüft wird.

Fig. 13 zeigt ein nicht erfindungsgemäßes Beispiel eines Verfahrens 23 zur Bestimmung der elektrischen Leitfähigkeit κ eines flüssigen Mediums 6 mittels eines oben dargestellten Leitfähigkeitssensors 1, der ein konduktiv-induktives Verfahren realisiert. In einem ersten Schritt 27 wird ein Wechselstrom oder eine Wechselspannung an die erste Elektrode 2 und an die zweite Elektrode 3 angelegt. Dadurch bildet sich in der Flüssigkeit 6 ein elektrisches Feld aus, das eine sich ändernde magnetische Flussdichte $B$ in der ersten Spule 11 erzeugt. In einem nächsten Schritt 28 wird der daraus resultierende Strom durch die erste Spule 11 bestimmt und anschließend aus der Admittanz $Y_m$ in der Ansteuer- und Auswerteeinheit 5 die elektrische Leitfähigkeit κ bestimmt 26. In einem nächsten Schritt 29 folgt eine zweite Messung der elektrischen Leitfähigkeit κ mittels eines konduktiven oder induktiven Verfahrens, wodurch die erste Messung überprüft wird.

Die in Fig. 12 und Fig. 13 dargestellten Ausführungsbeispiele der Verfahren 23 eignen sich besonders gut zur Bestimmung eines großen Wertebereichs der Leitfähigkeit κ und insbesondere für den Nachweis von mittleren Werten.

**Bezugszeichen**

| 1  | Leitfähigkeitssensor |
| 2  | Elektrode |
| 3  | Elektrode |
| 4  | Strom- bzw. Spannungsquelle mit Strom- und Spannungsmesseinrichtung |
| 5  | Ansteuer- und Auswerteeinheit |
| 6  | Flüssigkeit |
| 7  | Elektrode |
| 8  | Elektrode |
| 9  | Stromquelle |
| 10 | Spannungsmesseinheit |
| 11 | erste Spule |
| 12 | zweite Spule |
| 13 | elektrisch isolierendes Rohr |

| 14 | Rohrquerschnitt |
| 15 | Spannungsquelle |
| 16 | Strommesseinheit |
| 17 | Innenbereich Rohr |
| 18 | Außenbereich Rohr |
| 19a, 19b | Klemmenpaar |
| 20a, 20b | Klemmenpaar |
| 21 | Abschirmung |
| 22 | Spannungs- oder Stromquelle |
| 23 | Verfahren zur Bestimmung der elektrischen Leitfähigkeit |
| 24 | Einspeisen eines Wechselstroms in die erste Spule |
| 25 | Messung der Spannung zwischen der ersten Elektrode und der zweiten Elektrode |
| 26 | Bestimmung der elektrischen Leitfähigkeit |
| 27 | Anlegen einer Wechselspannung oder eines Wechselstroms an die erste und die zweite Elektrode |
| 28 | Messung des Stromes in der ersten Spule |
| 29 | konduktive oder induktive Messung der elektrischen Leitfähigkeit |

**Patentansprüche**

1. Leitfähigkeitssensor (1) zur Messung der elektrischen Leitfähigkeit eines flüssigen Mediums (6), umfassend wenigstens eine erste Spule (11), eine Stromquelle (9) und eine Ansteuerungs- und Auswerteeinheit (5), wobei die Stromquelle (9) mit der ersten Spule (11) verbunden ist,
**dadurch gekennzeichnet,**

    **dass** zusätzlich wenigstens eine erste Elektrode (2) und eine zweite Elektrode (3) und wenigstens eine Spannungsmesseinheit (10) vorhanden sind, wobei die Spannungsmesseinheit (10) mit der ersten Elektrode (2) und der zweiten Elektrode (3) verbunden ist, wobei die Ansteuerungs- und Auswerteeinheit (5) mit der Stromquelle (9) und mit der Spannungsmesseinheit (10) verbunden ist und wobei die erste Elektrode (2) und die zweite Elektrode (3) derart angeordnet sind, dass die erste Elektrode (2) und die zweite Elektrode (3) keinen elektrischen Kontakt mit der ersten Spule (11) aufweisen und
    **dass** wenigstens eine elektrisch isolierende Einheit in Form eines elektrisch isolierenden Rohres (13) vorhanden ist, wobei die elektrisch isolierende Einheit einen Innenraum (17) und einen Außenraum (18) aufweist, wobei der Innenraum (17) offen ist, wobei die erste Spule (11) die elektrisch isolierende Einheit umgibt und wobei die erste Spule (11) und die erste Elektrode (2) und die zweite Elektrode (3) parallel zueinander entlang der elektrisch isolierenden Einheit angeordnet sind, und dass der Leitfähigkeitssensor geeignet ist für einen Betrieb, in dem das elektrisch isolierende Rohr (13) mit der zu vermessenden Flüssigkeit (6) gefüllt ist und von der Flüssigkeit (6) umgeben ist und
    **dass** die Ansteuerungs- und Auswerteeinheit derart konfiguriert ist, im Betrieb ein Verfahren gemäß einem der Ansprüche 8 bis 11 durchzuführen.

2. Leitfähigkeitssensor (1) nach Anspruch 1, **dadurch gekennzeichnet, dass** die erste Elektrode (2) und die zweite Elektrode (3) im Innenraum (17), insbesondere an der Innenseite der elektrisch isolierenden Einheit angeordnet sind.

3. Leitfähigkeitssensor (1) nach einem der Ansprüche 1 bis 2, **dadurch gekennzeichnet, dass** die erste Spule (11) zwischen der ersten Elektrode (2) und der zweiten Elektrode (3) angeordnet ist.

4. Leitfähigkeitssensor (1) nach einem der Ansprüche 2 bis 3, **dadurch gekennzeichnet, dass** die erste Elektrode (2) und die zweite Elektrode (3) an jeweils einem Ende der elektrisch isolierenden Einheit angeordnet sind.

5. Leitfähigkeitssensor (1) nach einem der Ansprüche 1 bis 2, **dadurch gekennzeichnet, dass** die erste Elektrode (2) und die zweite Elektrode (3) auf derselben Seite der ersten Spule (11) angeordnet sind.

6. Leitfähigkeitssensor (1) nach einem der Ansprüche 1 bis 5, **dadurch gekennzeichnet, dass** an wenigstens einer Seite der ersten Spule (11) eine Abschirmung (21), insbesondere ein elektrisch leitfähiges und/oder ferromagnetisches Blech oder eine elektrisch leitfähige und/oder ferromagnetische Folie, zur Vermeidung einer Kopplung zwischen der ersten Spule (11) und der ersten Elektrode (2) und/oder der zweiten Elektrode (3) angeordnet ist.

7. Leitfähigkeitssensor (1) nach einem der Ansprüche 1 bis 6, **dadurch gekennzeichnet, dass** wenigstens eine zweite Spule (12) vorhanden ist, wobei die zweite Spule (12) mit der ersten Spule (11) parallel oder in Serie geschaltet ist oder keine Verbindung mit der ersten Spule (11) aufweist.

8. Verfahren (23) zur Bestimmung der elektrischen Leitfähigkeit eines flüssigen Mediums (6) mittels eines in dem flüssigen Medium (6) angeordneten Leitfähigkeitssensors (1),

wobei der Leitfähigkeitssensor wenigstens eine erste Spule (11), eine Stromquelle (9) und eine Ansteuerungs- und Auswerteeinheit (5) umfasst, wobei die Stromquelle (9) mit der ersten Spule (11) verbunden ist, wobei zusätzlich wenigstens eine erste Elektrode (2) und eine zweite Elektrode (3) und wenigstens eine Spannungsmesseinheit (10) vorhanden sind, wobei die Spannungsmesseinheit (10) mit der ersten Elektrode (2) und der zweiten Elektrode (3) verbunden ist, wobei die Ansteuerungs- und Auswerteeinheit (5) mit der Stromquelle (9) und mit der Spannungsmesseinheit (10) verbunden ist und wobei die erste Elektrode (2) und die zweite Elektrode (3) derart angeordnet sind, dass die erste Elektrode (2) und die zweite Elektrode (3) keinen elektrischen Kontakt mit der ersten Spule (11) aufweisen und wobei wenigstens eine elektrisch isolierende Einheit in Form eines elektrisch isolierenden Rohres (13) vorhanden ist, wobei die elektrisch isolierende Einheit einen Innenraum (17) und einen Außenraum (18) aufweist, wobei der Innenraum (17) offen ist, wobei die erste Spule (11) die elektrisch isolierende Einheit umgibt und wobei die erste Spule (11) und die erste Elektrode (2) und die zweite Elektrode (3) parallel zueinander entlang der elektrisch isolierenden Einheit angeordnet sind **dadurch gekennzeichnet, dass** das Verfahren (23) die folgenden Schritte umfasst:

- Erzeugen (24) eines Wechselstroms in der ersten Spule (11) durch die Stromquelle (9), wodurch die erste Spule (11) eine sich zeitlich ändernde magnetische Flussdichte erzeugt, die ein elektrisches Feld in dem flüssigen Medium (6) induziert, woraus im Fall einer nicht verschwindenden elektrischen Leitfähigkeit $\kappa$ der Flüssigkeit (6) ein elektrischer Stromfluss in Form eines Wirbelstroms mit einer Stromdichte $J_F$ entlang eines geschlossenen Strompfades, der durch den freien Rohrquerschnitt (14) und durch den mit der Flüssigkeit gefüllten Außenbereich des elektrisch isolierenden Rohrs (13) gebildet wird, resultiert,
- Messen (25) der Spannung zwischen der ersten Elektrode (2) und der zweiten Elektrode (3) durch die Spannungsmesseinheit (10),
- Übertragung der Werte der Spannung und des Stroms an die Ansteuer- und Auswerteeinheit,
- Bestimmen (26) der elektrischen Leitfähigkeit aus den Werten der Spannung und des Stroms durch die Ansteuer- und Auswerteeinheit (5).

9. Verfahren (23) nach Anspruch 8, **dadurch gekennzeichnet, dass** der Leitfähigkeitssensor (1) wenigstens eine zweite Spule (12) aufweist, wobei die zweite Spule (12) keine Verbindung mit der ersten Spule (11) aufweist oder parallel oder in Serie zu der ersten Spule (11) geschaltet ist und wobei die Bestimmung der elektrischen Leitfähigkeit sowohl mittels der ersten Spule (11) als auch mittels der zweiten Spule (12), vorzugsweise über die Kombination der ersten Spule (11) und der zweiten Spule (12), erfolgt.

10. Verfahren (23) nach einem der Ansprüche 8 bis 9, **dadurch gekennzeichnet, dass** an die erste Elektrode (2) und an die zweite Elektrode (3) ein Strom angelegt wird, und dass die Leitfähigkeit konduktiv durch die erste Elektrode (2) und die zweite Elektrode (3) bestimmt wird, wodurch die erste Messung überprüft wird.

11. Verfahren nach einem der Ansprüche 8 bis 10, **dadurch gekennzeichnet, dass** das Verfahren unter Einsatz eines Leitfähigkeitssensors (1) nach einem der Ansprüche 2 bis 7 durchgeführt wird.

**Claims**

1. Conductivity sensor (1) for measuring the electrical conductivity of a liquid medium (6) comprising at least a first coil (11), a current source (9) and a control and evaluation unit (5), wherein the current source (9) is connected to the first coil (11),
**characterized in**

**that**, additionally, at least a first electrode (2) and a second electrode (3) and at least one voltage measuring unit (10) are provided, wherein the voltage measuring unit (10) is connected to the first electrode (2) and the second electrode (3), wherein the control and evaluation unit (5) is connected to the current source (9) and to the voltage measuring unit (10), and wherein the first electrode (2) and the second electrode (3) are arranged in such a manner that the first electrode (2) and the second electrode (3) have no electrical contact with the first coil (11), and

**that** at least one electrically insulating unit, preferably an electrically insulating tube (13), is provided, wherein the electrically insulating unit has an inner space (17) and an outer space (18), wherein the inner space (17) is open, wherein the first coil (11) surrounds the electrically insulating unit and wherein the first coil (11) and the first electrode (2) and the second electrode (3) are arranged parallel to one another along the electrically insulating unit, and

**that** the conductivity sensor is suitable for an operation in which the electrically insulating tube (13) is filled with the liquid (6) to be measured and is surrounded by the liquid (6), and

**that** the control and evaluation unit is configured in such a way that, during operation, a method according to one of claims 8 to 11 is carried out.

2. Conductivity sensor (1) according to claim 1, **characterized in that** the first electrode (2) and the second electrode (3) are arranged in the inner space (17), in particular on the inner side of the electrically insulating unit.

3. Conductivity sensor (1) according to any one of claims 1 to 2, **characterized in that** the first coil (11) is arranged between the first electrode (2) and the second electrode (3).

4. Conductivity sensor (1) according to any one of claims 2 to 3, **characterized in that** the first electrode (2) and the second electrode (3) are each arranged at one end of the electrically insulating unit.

5. Conductivity sensor (1) according to any one of claims 1 to 2, **characterized in that** the first electrode (2) and the second electrode (3) are arranged on the same side of the first coil (11).

6. Conductivity sensor (1) according to any one of claims 1 to 5, **characterized in that** a shield (21), in particular an electrically conductive and/or ferromagnetic plate or an electrically conductive and/or ferromagnetic film, is arranged on at least one side of the first coil (11) in order to avoid coupling between the first coil (11) and the first electrode (2) and/or the second electrode (3).

7. Conductivity sensor (1) according to any one of claims 1 to 6, **characterized in that** at least a second coil (12) is present, wherein the second coil (12) is connected in parallel or in series to the first coil (11), or there is no connection to the first coil (11).

8. Method (23) for determining the electrical conductivity of a liquid medium (6) by means of a conductivity sensor (1) arranged in the liquid medium (6), wherein the conductivity sensor (1) comprises at least a first coil (11), a current source (9) and a control and evaluation unit (5), wherein the current source (9) is connected to the first coil (11),

wherein, additionally, at least a first electrode (2) and a second electrode (3) and at least a voltage measuring unit (10) are provided, wherein the voltage measuring unit (10) is connected to the first electrode (2) and the second electrode (3), wherein the control and evaluation unit (5) is connected to the current source (9) and to the voltage measuring unit (10), and wherein the first electrode (2) and the second electrode (3) are arranged in such a manner that the first electrode (2) and the second electrode (3) have no electrical contact to the first coil (11),

wherein at least one electrically insulating unit in the form of an electrically insulating tube (13) is present, wherein the electrically insulating unit has an inner space (17) and an outer space (18), wherein the inner space (17) is open, wherein the first coil (11) surrounds the electrically insulating unit, and wherein the first coil (11) and the first electrode (2) and the second electrode (3) are arranged parallel to each other along the electrically insulating unit,

**characterized in**

**that** the method (23) comprises the following steps:

- generating (24) an alternating current in the first coil (11) by the current source (9), whereby the first coil (11) produces a temporally changing magnetic flux density which induces an electric field in the liquid medium (6), which, in the case of a non-vanishing electrical conductivity $\kappa$ of the liquid (6), results in an electrical current flow in the form of an eddy current with a current density $J_F$ along a closed current path which is formed by the free tube cross-section (14) and by the outer region of the electrically insulating tube (13) filled with the liquid

- measuring (25) the voltage between the first electrode (2) and the second electrode (3) by the voltage measuring unit (10),
- transferring the values of the voltage and the current to the control and evaluation unit (5),
- determining (26) the electrical conductivity from the values of the voltage and the current by the control and evaluation unit (5).

9. Method (23) according to claim 8, **characterized in that** the conductivity sensor (1) comprises at least a second coil (12), wherein the second coil (12) has no connection with the first coil (11) or is connected parallel or is in series to the first coil (11) and wherein determining the electrical conductivity is carried out both by means of the first coil (11) and by means of the second coil (12), preferably the combination of the first coil (11) and the second coil (12).

10. Method (23) according to any one of claims 8 to 9, **characterized in that** a current is applied to the first electrode (2) and to the second electrode (3), and that the conductivity is determined conductively by the first electrode (2) and the second electrode (3), whereby the first measurement is checked.

11. Method according to any one of claims 8 to 10, **characterized in that** the method is carried out using a conductivity sensor (1) according to any one of claims 2 to 7.


**Revendications**

1. Capteur de conductivité (1) destiné à mesurer la conductivité électrique d'un milieu liquide (6), ledit capteur de conductivité comprenant au moins une première bobine (11), une source de courant (9) et une unité de commande et d'évaluation (5), la source de courant (9) étant reliée à la première bobine (11),
   **caractérisé en ce que**

   au moins une première électrode (2) et une deuxième électrode (3) ainsi qu'au moins une unité de mesure de tension (10) sont également présentes, l'unité de mesure de tension (10) étant reliée à la première électrode (2) et à la deuxième électrode (3), l'unité de commande et d'évaluation (5) étant reliée à la source de courant (9) et à l'unité de mesure de tension (10) et la première électrode (2) et la deuxième électrode (3) étant disposées de manière à ce que la première électrode (2) et la deuxième électrode (3) n'aient aucun contact électrique avec la première bobine (11) et
   au moins une unité électriquement isolante est présente sous forme d'un tube électriquement isolant (13), l'unité électriquement isolante comportant un espace intérieur (17) et un espace extérieur (18), l'espace intérieur (17) étant ouvert, la première bobine (11) entourant l'unité électriquement isolante et la première bobine (11) et la première électrode (2) et la deuxième électrode (3) étant disposées parallèlement l'une à l'autre le long de l'unité électriquement isolante, et **en ce que** le capteur de conductivité est approprié à un fonctionnement dans lequel le tube électriquement isolant (13) est rempli du liquide (6) à mesurer et est entouré par le liquide (6) et l'unité de commande et d'évaluation est conçue pour mettre en œuvre un procédé selon l'une des revendications 8 à 11 pendant le fonctionnement.

2. Capteur de conductivité (1) selon la revendication 1, **caractérisé en ce que**
   la première électrode (2) et la deuxième électrode (3) sont disposées dans l'espace intérieur (17), en particulier du côté intérieur de l'unité électriquement isolante.

3. Capteur de conductivité (1) selon l'une des revendications 1 à 2, **caractérisé en ce que** la première bobine (11) est disposée entre la première électrode (2) et la deuxième électrode (3).

4. Capteur de conductivité (1) selon l'une des revendications 2 à 3, **caractérisé en ce que** la première électrode (2) et la deuxième électrode (3) sont disposées à une extrémité de l'unité électriquement isolante.

5. Capteur de conductivité (1) selon l'une des revendications 1 à 2, **caractérisé en ce que** la première électrode (2) et la deuxième électrode (3) sont disposées du même côté de la première bobine (11).

6. Capteur de conductivité (1) selon l'une des revendications 1 à 5, **caractérisé en ce que** sur au moins un côté de la première bobine (11) est disposé un blindage (21), notamment une tôle électriquement conductrice et/ou ferromagnétique ou un film électriquement conducteur et/ou ferromagnétique, afin d'éviter le couplage entre la première bobine (11) et la première électrode (2) et/ou la deuxième électrode (3) .

**7.** Capteur de conductivité (1) selon l'une des revendications 1 à 6, **caractérisé en ce qu'**au moins une deuxième bobine (12) est présente, la deuxième bobine (12) étant montée en parallèle ou en série avec la première bobine (11) ou n'ayant aucune liaison avec la première bobine (11).

**8.** Procédé (23) de détermination de la conductivité électrique d'un milieu liquide (6) au moyen d'un capteur de conductivité (1) disposé dans le milieu liquide (6),

le capteur de conductivité comprenant au moins une première bobine (11), une source de courant (9) et une unité de commande et d'évaluation (5), la source de courant (9) étant reliée à la première bobine (11), au moins une première électrode (2) et une deuxième électrode (3) et au moins une unité de mesure de tension (10) étant en outre présentes, l'unité de mesure de tension (10) étant reliée à la première électrode (2) et à la deuxième électrode (3), l'unité de commande et d'évaluation (5) étant reliée à la source de courant (9) et à l'unité de mesure de tension (10) et la première électrode (2) et la deuxième électrode (3) étant disposées de manière à ce que la première électrode (2) et la deuxième électrode (3) n'aient aucun contact électrique avec la première bobine (11) et au moins une unité électriquement isolante étant présente sous la forme d'un tube électriquement isolant (13), l'unité électriquement isolante comportant un espace intérieur (17) et un espace extérieur (18), l'espace intérieur (17) étant ouvert, la première bobine (11) entourant l'unité électriquement isolante et la première bobine (11) et la première électrode (2) et la deuxième électrode (3) étant disposées parallèlement l'une à l'autre le long de l'unité électriquement isolante, **caractérisé en ce que** le procédé (23) comprend les étapes suivantes :

- générer (24) un courant alternatif dans la première bobine (11) par le biais de la source de courant (9), ce qui permet à la première bobine (11) de générer une densité de flux magnétique variant dans le temps qui induit dans le milieu liquide (6) un champ électrique duquel il résulte, dans le cas d'une conductivité électrique k non nulle du liquide (6), un flux de courant électrique s'écoule sous la forme d'un courant tourbillonnaire d'une densité de courant $J_F$ le long d'un trajet de courant fermé qui est formé par la section transversale de tube libre (14) et par la zone extérieure, remplie du liquide, du tube électriquement isolant (13),
- mesurer (25) la tension entre la première électrode (2) et la deuxième électrode (3) par le biais de l'unité de mesure de tension (10),
- transmettre les valeurs de tension et de courant à l'unité de commande et d'évaluation,
- déterminer (26) la conductivité électrique à partir des valeurs de tension et de courant par le biais de l'unité de commande et d'évaluation (5).

**9.** Procédé (23) selon la revendication 8, **caractérisé en ce que** le capteur de conductivité (1) comporte au moins une deuxième bobine (12), la deuxième bobine (12) n'ayant aucune liaison avec la première bobine (11) ou étant montée en parallèle ou en série avec la première bobine (11) et la détermination de la conductivité électrique étant effectuée aussi bien au moyen de la première bobine (11) qu'au moyen de la deuxième bobine (12), de préférence par le biais de la combinaison de la première bobine (11) et de la deuxième bobine (12).

**10.** Procédé (23) selon l'une des revendications 8 à 9, **caractérisé en ce qu'**un courant est appliqué à la première électrode (2) et à la deuxième électrode (3), et **en ce que** la conductivité est déterminée de manière conductrice à travers la première électrode (2), et la deuxième électrode (3), ce qui vérifie la première mesure.

**11.** Procédé selon l'une des revendications 8 à 10, **caractérisé en ce que** le procédé est mis en œuvre à l'aide d'un capteur de conductivité (1) selon l'une des revendications 2 à 7.

Fig. 1

Fig. 2

Fig. 3

Fig. 4

Fig. 5

Fig. 6

Fig. 7

Fig. 8

Fig. 9

Fig. 10

Fig. 11

23

24

25

26

29

Fig. 12

23

27

28

26

29

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10212494 A1
- DE 19537059 C2
- US 20020142935 A
- DE 19643967 A1
- DE 2501812 C2
- DE 4307379 C1
- DE 102005026052 B3
- DE 19851146 B4

- DE 102006025194 A1
- US 3806798 A
- DE 102006056174 A1
- US 7078909 B2
- US 2004012395 A1
- JP H09329633 A
- US 4810963 A
- JP S62157559 A